# EUROPEAN PATENT APPLICATION

(11) **EP 3 770 306 A1**
(43) Date of publication of application: **27.01.2021**
(21) Application number: 20162639.7
(22) Date of filing: 12.03.2020
(51) Int. Cl.: C30B 15/00, C30B 29/08

(54) **HEAVILY DOPED N-TYPE GERMANIUM**

(71) Applicant: Umicore, 1000 Brussels (BE)
(72) Inventor: VANPAEMEL, Johannes, 2250 Olen (BE); DESSEIN, Kristof, 2250 Olen (BE); DEPUYDT, Ben, 2250 Olen (BE)

(57) **Abstract**

The invention concerns monocrystalline Ge, n-type doped with phosphorus, and having a resistivity of less than 10 mOhm.cm, characterized in that it is dislocation-free. Such crystals can be obtained by using the Czochralski pulling technique with GeP as dopant.

## Description

The present invention concerns a process for the manufacture of dislocation-free monocrystalline Ge, n-type doped with phosphorus, and having a resistivity of less than 10 mOhm.cm. It also concerns the n-type doped material in the form of large diameter bulk crystals, as well as the wafers derived from these crystals.

The market for n-type Ge wafers is mainly for opto-electronic devices such as vertical-cavity surface emitting lasers (VCSEL) or mid-infrared plasmonic sensors. A VCSEL is a type of semiconductor laser diode with laser beam emission perpendicular from the top surface. VCSELs are used in various laser products, including computer mice, fiber optic communications, laser printers, face recognition, and smart glasses. Plasmonic sensors are based on collective oscillations of free electrons and are suited for various applications such as the detection of molecules.

N-type doping and a low resistivity are desirable for these applications, as high electron densities achieved in these highly doped wafers enable the plasmonic effect in the germanium films. However, dislocations often degrade their performance.

P-type doped germanium wafers, on the other hand, are not suitable for infra-red plasmonics due to the large plasmonic losses [Frigerio et al., Physical Review B 94, 085202, 2016].

Low resistivity dislocation-free semiconductor wafers have been described in US7341787. Very low resistivities are envisaged, such as lower than 2 mOhm.cm. To this end, at least two electrically active dopants, which belong to the same group of the periodic system of elements, are simultaneously added. This is said to avoid the problem that, above certain concentrations, some of the dopant atoms incorporated in the semiconductor material may be electrically inactive. This document, although mentioning Si, Ge, and Si-Ge alloys, is clearly dedicated to the doping of Si. No details are disclosed with respect to Ge, and in particular also not for the source of the dopants used.

Spitzer et al. [J. Appl. Phys. 32, 1822, 1961] describe the preparation of Ge single crystals heavily doped with Sb, As, and P. Resistivities well below 2 mOhm.cm are reported. Herein, the phosphorus-doped samples are all obtained by pulling single crystals with calcium orthophosphate as the source. However, the use of calcium orthophosphate as dopant will necessarily preclude obtaining dislocation-free crystals, as shown in the Comparative Example below.

US8574363 teaches that a high doping level in a silicon-based semiconductor crystal can also be obtained by using a so-called dopant chamber that, for example, includes phosphorus. The chamber is brought into close proximity of the melt. When the temperature is raised to the melting point of phosphorus, the phosphorus is released as a gas, and a part of it will be incorporated into the melt, while the rest is lost to the environment. The gas phase operation thus requires additional attention and calculations to predict the amount of phosphorous released to the melt. In case of doping silicon with phosphorous and germanium, US8574363 further teaches the use of two separate chambers, one for phosphorous, supplied via evaporation, the other for germanium, supplied by liquefication. US7132091 indicates using a dopant chamber where the cover is partially dissolved when lowering it into the melt. The usage of such a chamber can introduce undesired contaminants into the melt.

The present invention aims at the preparation of monocrystalline Ge, n-type doped with phosphorus, and having a resistivity of less than 10 mOhm.cm, characterized in that it is dislocation-free.

Another embodiment of the invention concerns dislocation-free monocrystalline Ge, n-type doped with phosphorus, and having a resistivity of less than 10 mOhm.cm, in which phosphorus is the single dopant. This simplifies the process and allows a better process control, but also a more precise prediction of the resistivity of a formed crystal ingot. The combination of a high n-type doping with the fact that the wafers are dislocation-free unlocks possibilities to enhance the behavior of the aforementioned opto-electronic devices.

Another embodiment according to any previous embodiment concerns the above monocrystalline Ge, obtainable by supplying the phosphorus in the form of GeP. This ensures that a phosphorus-doped, monocrystalline, and dislocation-free product is obtained. Using GeP as dopant source is highly preferred over, for example, red or white phosphorus because of safety precautions needed when handling the latter two. Moreover, GeP is available in high purity (99,999%), minimizing the addition of undesired impurities to the melt.

Another embodiment according to any previous embodiment concerns monocrystalline Ge in the form of a Czochralski-grown crystal ingot.

Another embodiment according to any previous embodiment concerns monocrystalline Ge in the form of wafers derived from a Czochralski-grown crystal ingot. Such wafers may preferably have a thickness of 140 to 1000 µm, and a diameter of 5 to 35 cm.

Another embodiment according to any previous embodiment concerns the use of monocrystalline Ge for vertical-cavity surface emitting lasers or infrared plasmonic sensors.

To this end, a process was developed comprising the following steps:
- providing a Czochralski pulling furnace;
- feeding Ge and GeP into the furnace in such relative quantities as to obtain a dopant level of at least 1 x 10¹⁸/cm³ in the crystal; and,
- pulling a crystal.
Optional additional steps are:
- cutting the crystal into wafers by means of wire-sawing;
- grinding the wafers with a coarse grit;
- chemical-mechanical polishing;
- cleaning the wafer surface.

This process is illustrated in the following Example.

A load of 100 kg of high purity germanium is introduced into a Czochralski furnace, in a graphite crucible, to which 62.3 g of GeP is added as a dopant.

This amount of dopant corresponds to a dopant level in the crystal, which varies between 1 and 6 x 10¹⁸/cm³, corresponding to a variation in the resistivity of about 2 to 6 mOhm.cm. The variation is due to the well-known fact of impurity segregation at the solid interface during crystal growth. As a result, the concentration of phosphorus increases towards the tail of the crystal, causing a lower resistivity there.

The furnace is first heated to 1000 °C in a nitrogen environment, so as to melt the germanium. Around 725 °C, germanium phosphide dissociates into solid Ge and liquid phosphorus. At 1000 °C, the germanium is also molten, and phosphorus is incorporated into the melt. When the germanium is fully molten, the temperature of the furnace is lowered to 950 °C. After 6 hours, the temperature is stabilized, whereupon a germanium seed crystal is lowered through the shaft of the furnace until it contacts the molten bath. A procedure called "Dash necking", well known to the skilled person, is then executed in order to initiate the growth. More specifically, a thin 5 mm diameter crystal is grown for a length of 150 mm. The crystal is then slowly pulled up at a controlled rate of 10 mm/h so as to increase its diameter to 150 mm. The diameter of the crystal is then stabilized by controlling the heater temperature and/or the pulling rate. This phase is commonly called body growth. A pulling rate of about 10 mm/h is achieved.

At the end of the body growth, a tail is formed on the crystal by steadily reducing its diameter, whereupon the crystal is detached from the melt. This procedure is useful to minimize the thermal shock as an aid to avoid dislocations. The crystal is pulled up into the shaft of the furnace and slowly cooled to below 50 °C for 28 h. It is then unloaded from the furnace.

The crystal is sawn perpendicular to the crystal axis into cylindrical pieces, and the resistivity is measured on 6 different locations along the length of the crystal using a 4-point probe. The results are reported in Table 1.

**Table 1: Resistivity function of the location along the body of the crystal**

| | | | | | |
|---|---|---|---|---|---|
| Location (distance from the start of body growth in cm) | 0 | 28 | 56 | 84 | 105 |
| Resistivity (Ohm.cm) | 5.9 | 4.1 | 3.8 | 3.4 | 2.3 |

It is shown that doping a germanium melt with GeP effectively results in low-resistive, n-type germanium crystals with a resistivity ranging between 2 and 6 mOhm.cm. This variation in resistivity is perfectly acceptable for the intended applications. Theoretical calculations further indicate that with these quantities of added dopant, close to all phosphorus atoms are electrically active inside of the germanium lattice.

It is then verified that a dislocation-free crystal is obtained. This is done by etching a cross sectional piece taken from the tail of the crystal with a dislocation-revealing chemical. In this case, a solution is prepared consisting of 75 g of Cu(NO₃)₂·3H2O, 300 mL H₂O, 300 mL HNO₃ (69%), and 600 mL HF (49%) to etch the crystal piece. The surface is then analyzed with a microscope to confirm the absence of dislocations.

Analyzing the tail of the crystal is sufficient to ensure that the crystal as a whole is dislocation-free, because dislocations generated in the crystal body multiply and extend towards the crystal's tail.

For the obtention of wafers, the crystal can be further processed as follows.
The crown and tail of the crystal are cropped and subsequently the crystal is ground to the desired diameter using cylindrical grinding. A flat or notch is then machined on the rounded crystal to mark the crystal orientation. Afterwards, a wire-saw cuts the crystal into individual wafers. These wafers are laser-marked with a unique identification code for tracking purposes.

The edge of the wafer is rounded to prevent wafer breakage in further processing. In order to remove thickness variations that are present after sawing, the wafer surface is ground with a course grit. Any sub-surface damage induced by this process is removed by chemical etching. Then, chemical-mechanical polishing is applied until a mirror-like surface is obtained. A final clean ensures an "epi-ready" surface for the growth of various epi-layers.

### Comparative Example

In a Czochralski furnace, the crucible is filled with 2500 g of germanium and 5 g of calcium orthophosphate as dopant. The furnace is then heated to its normal operating temperature of 1100 °C. It is however observed that a significant part of the dopant does not dissolve, forming particles floating on the surface of the germanium melt. The same crystal-growth and analysis procedures are performed as in the above Example. The analysis of the crystal shows multiple dislocations, probably due to the absorption of particles near the solid-liquid interface.
It therefore must be concluded that the use of calcium orthophosphate as dopant necessarily precludes the obtention of dislocation-free crystals.

## Claims

1. Monocrystalline Ge, n-type doped with phosphorus, and having a resistivity of less than 10 mOhm.cm, **characterized in that** it is dislocation-free.

2. Monocrystalline Ge according to claim 1, wherein phosphorus is the single dopant.

3. Monocrystalline Ge according to claims 1 or 2, wherein the monocrystalline Ge is in the form of a Czochralski-grown crystal ingot.

4. Monocrystalline Ge according to any one of claims 1 to 3, wherein the monocrystalline Ge is in the form of wafers, cut from a Czochralski-grown crystal ingot.

5. Wafers according to claim 4, wherein the wafers have a thickness of 140 to 1000 µm, and a diameter of 5 to 35 cm.

6. Process for the manufacture of monocrystalline Ge according to claim 3, comprising the steps of:
- providing a Czochralski pulling furnace;
- feeding Ge and GeP into the furnace in such relative quantities as to obtain a dopant level of at least 1 x 10¹⁸/cm³; and,
- pulling a crystal.

7. Process according to claim 6, comprising the additional steps of:
- cutting the crystal into wafers by means of wire-sawing;
- grinding the wafers with a coarse grit;
- chemical-mechanical polishing;
- cleaning the wafer surface.

8. Use of monocrystalline Ge according to any one of claims 1 to 5 for vertical-cavity surface emitting lasers or infrared plasmonic sensors.
